# EUROPEAN PATENT APPLICATION

(11) **EP 2 575 165 A1**
(43) Date of publication of application: **03.04.2013**
(21) Application number: 10841801.3
(22) Date of filing: 16.08.2010
(51) Int. Cl.: H01L 23/15, H01L 23/48, H03H 9/05

(54) **CERAMIC PACKAGING BASE BOARD**

(30) Priority: 24.06.2010 CN 201020238271 U
(71) Applicant: Chaozhou Three-Circle (Group) Co., Ltd., Chaozhou, Guangdong 515646 (CN); Nanchong Three-Circle Electronics Co., Ltd., Nanchongn, Sichuan 637100 (CN)
(72) Inventor: QIU, Jihua, Chaozhou Guangdong 515600 (CN); LIU, Jianwei, Chaozhou Guangdong 515600 (CN)
(74) Representative: Vandeberg, Marie-Paule L.G.
(86) International application number: PCT/CN2010/076032
(87) International publication number: WO 2011/160332

(57) **Abstract**

A ceramic package base comprising a package substrate (1), a circuit layout layer printed on the package substrate and a package fixed layer arranged on the periphery of the package substrate and the circuit layout layer, wherein the circuit layout layer comprises at least one metal slurry (3) region. At least one compensation metal slurry region (4) which corresponds to the metal slurry region is further arranged in a blank region (2) which is not provided with metal slurry (3). To apply a metal slurry pattern onto the package substrate of the ceramic package, a compensation metal slurry region (4) which is uniformly and symmetrically distributed with the metal slurry region (3) is added on the package substrate, thereby enabling the shrinkage of the metal slurry (3) and ceramic (1) to be uniform during sintering, reducing the stress, further reducing the deformation possibility of the base after sintering, effectively improving the deformation situation of the base, providing reliable guarantee for follow-up mounting of a crystal element, further improving the finished product rate of a base product, greatly reducing the cost and improving the competitiveness of the product.

## Description

### Technical Field

The application relates to a semiconductor package carrier, in particular to a ceramic package base.

### Background of the Invention

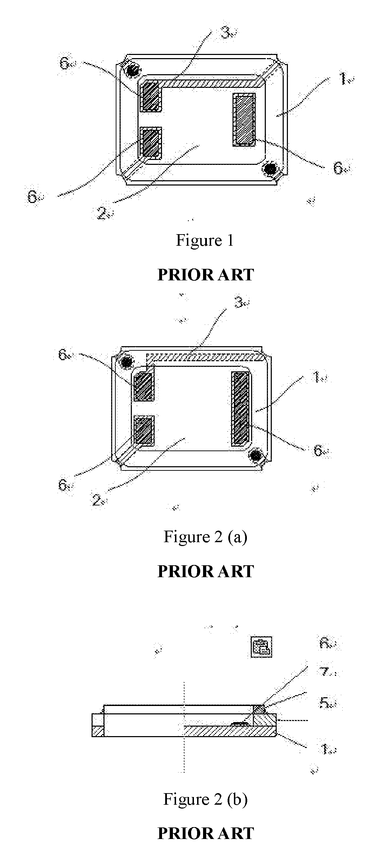

Most of package bases in the prior art are ceramic package bases, the co-sintering technology of metal and ceramic is taken as the basis, that is metal slurry patterns are printed on ceramic substrates, and then high-temperature or low-temperature co-sintering is carried out for preparation. As carrying media for semiconductor packaging operation, the ceramic package bases shall have better characteristics of electrical interconnection, high temperature resistance and anti-deformation property. However, for the ordinary ceramic package bases, the metal slurry patterns thereon are often non-uniform, as shown in Figure 1 to Figure 4, many blank regions 2 exist on the ceramic substrates 1, and metal slurry 3 is not distributed on the regions, so that the structures in the places are relatively thin, thereby being easy to cause the deformation of the bases due to excessive stress when co-sintering the metal and the ceramic; in addition, not only for the substrates made of the ceramic, even for the substrates made of other materials, the deformation of the bases can be caused due to different shrinkage of the different materials during sintering and other high-temperature processes.

Many manufacturers provided many improvement schemes against the defect, the reinforcing metal patterns like nets or other special shapes can be arranged in the blank regions on ceramic package baseplates for uniformly dispersing the stress or partially reinforcing the strength, but the metal slurry patterns on the package baseplates in the structure often only consider the interconnection relationship of electronic circuits, and the asymmetric distribution often occurs, thereby being easy to cause the deformation of the bases due to excessive stress caused by asymmetric shrinkage when sintering during the co-sintering process of the metal and the ceramic. Therefore, not only the product appearance is affected, but also the follow-up packaging process becomes difficult.

### Summary of the invention

The invention aims at solving the above problems and providing a ceramic package base which can effectively improve the deformation of the base.

In order to realize the purposes, the technical scheme of the invention is as follows:
The ceramic package base comprises a package substrate, a circuit layout layer printed on the package substrate and a package fixed layer arranged on the periphery of the package substrate and the circuit layout layer, wherein the circuit layout layer comprises at least one metal slurry region, and at least one compensation metal slurry region which corresponds to the metal slurry region is further arranged in a blank region which is not provided with metal slurry. Therefore, through the design of the compensation metal slurry region which corresponds to the metal slurry region, the characteristic that a metal slurry pattern on the ordinary package base only considers the interconnection relationship of electronic circuits and is in asymmetric and non-uniform distribution can be changed, thereby avoiding the deformation of the base due to excessive stress. And a plurality of the compensation metal slurry regions as compensation printed circuits are added for deformation compensation of the metal slurry regions, the shrinkage of the different metal slurry regions can produce the symmetrical technical effect during sintering and other high-temperature processes, thereby reducing the stress, further reducing the deformation caused by excessive stress due to asymmetric shrinkage of the metal slurry and ceramic during sintering, and further greatly improving the deformation problem of the package base.

The package fixed layer comprises:
A package side wall layer which is arranged on the periphery of the circuit layout layer for defining the internal size of a cavity of the ceramic package base.
At least two support layers which are arranged on two sides of the circuit layout layer exposed from the package side wall layer;
And a cover body support layer which is arranged on the package side wall layer. The structure can lead the structure of the package base to be firmer.

Bosses are further produced in the metal slurry region, and the support layers are the bosses.

The metal slurry region and the compensation metal slurry region are uniformly distributed on the package substrate. Therefore, the stress deformation between the different metal slurry region and the compensation metal slurry region becomes more uniform and symmetrical, and the final deformation of the package base becomes very small.

As a further improvement of the application, metal slurry patterns of the metal slurry region and the compensation metal slurry region are symmetrical or identical or similar. The design can lead the shrinkage process to be more uniform and lead the deformation to be smaller. Simultaneously, the technical effect of reducing mutual interferences among the electronic circuits in the metal slurry region can be achieved. The metal slurry region and the compensation metal slurry region are not electrically connected so as to avoid affecting the metal slurry region and avoid the impacts on normal work of an original printed circuit.

The metal slurry region and the compensation metal slurry region are electrically connected.

As a further improvement of the application, the metal slurry regions and the compensation metal slurry regions are in the same number and symmetrically distributed on the package substrate. Thus, each metal slurry region has the compensation metal slurry region corresponding to it, and the mutual stress can be offset during the shrinkage process after sintering, thereby leading the whole package base to be in the relatively balanced state.

As a further improvement of the application, the metal slurry region is one and the compensation metal slurry region is also one. In such a way, the shrinkage of the slurry is symmetrical, and the effect of offsetting the stress can be optimal.

As an even further improvement of the application, the metal slurry regions and the compensation metal slurry regions are in the same number and distributed in a mutual staggered manner. Then the compensation metal slurry regions can only be partially arranged according to the needs of actual situations under the situation that the blank region is limited; however, in order to lead the symmetrical shrinkage to achieve the better effect, the different slurry regions need to be distributed in the mutual staggered manner as far as possible.

The metal slurry patterns in the prior art only consider the interconnection of the electronic circuits, and the symmetrical design of the patterns do not carried out against the shrinkage difference between the metal and the ceramic during co-sintering, so that the deformation is easy to occur due to excessive stress caused by inconsistent shrinkage during sintering. Compared with the prior art, the application has the following benefits: to apply a metal slurry pattern onto the package substrate of the ceramic package provided by the application, a compensation metal slurry region which is uniformly and symmetrically distributed with the metal slurry region , is added on the package substrate, thereby enabling the shrinkage of the metal slurry and the ceramic to be uniform during sintering, reducing the stress and further reducing the deformation possibility of the base after sintering.

### Brief Description of the Drawings

Figure 1 is a schematic diagram of structure of package base in the prior art.
Figure 2 (a) is a schematic diagram of structure of package base in another structure in the prior art.
Figure 2 (b) is a schematic diagram of cross-section structure of Figure 2 (a).
Figure 3 is a schematic diagram of structure of package base in another structure in the prior art.
Figure 4 (a) is a schematic diagram of structure of package base in another structure in the prior art.
Figure 4 (b) is a schematic diagram of cross-section structure of Figure 4 (a).
Figure 5 is a schematic diagram of structure of package base adding compensation metal slurry region.
Figure 6 is a schematic diagram of structure of package base adding compensation metal slurry region of Figure 2 (a).
Figure 7 is a schematic diagram of structure of package base which adds compensation metal slurry region and is in another structure of Figure 2 (a).
Figure 8 is a schematic diagram of structure of package base adding compensation metal slurry region of Figure 3.
Figure 9 is a schematic diagram of structure of package base adding compensation metal slurry region of Figure 4 (a).

### Detailed Description of the Invention

In combination with figures, the invention is further described in detail.

The invention aims at providing a ceramic package base which can reduce the deformation caused by excessive stress due to asymmetric shrinkage of slurry when co-sintering ceramic and metal slurry.

### Embodiment 1

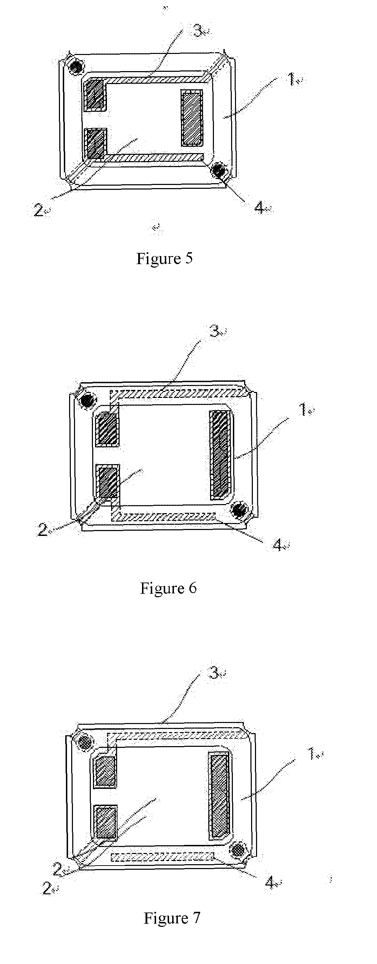

As shown in Figure 5, a ceramic package base comprises a package substrate, a circuit layout layer printed on the package substrate and a package fixed layer arranged on the periphery of the package substrate and the circuit layout layer, wherein the circuit layout layer comprises at least one metal slurry region 3, and at least one compensation metal slurry region 4 which corresponds to the metal slurry region 3 is further arranged in a blank region which is not provided with metal slurry 3. The preferential package substrate is a ceramic substrate 1, the metal slurry regions 3 and the compensation metal slurry regions 4 are in the same number and symmetrically distributed on the ceramic substrate 1.The figure only shows the situation containing one metal slurry region 3 and one compensation metal slurry region 4, from the figure, it can be seen that patterns of the metal slurry region 3 and the compensation metal slurry region 4 are identical and mutually symmetrical, and the metal slurry region 3 is electrically connected with the compensation metal slurry region 4. Figure 6 shows the situation of correspondingly adding the compensation metal slurry region 4 in Figure 2 (a), Figure 7 shows the situation which is similar to that in Figure 6, and the difference is that: in order to ensure that the normal operation of a printed electronic circuit on the original metal slurry region 3 is not affected, the compensation metal slurry region 4 is not electrically connected with the metal slurry region 3.

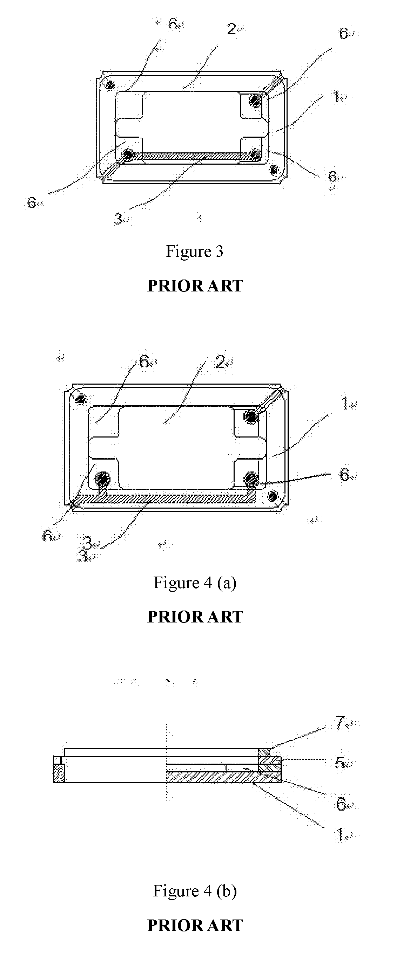

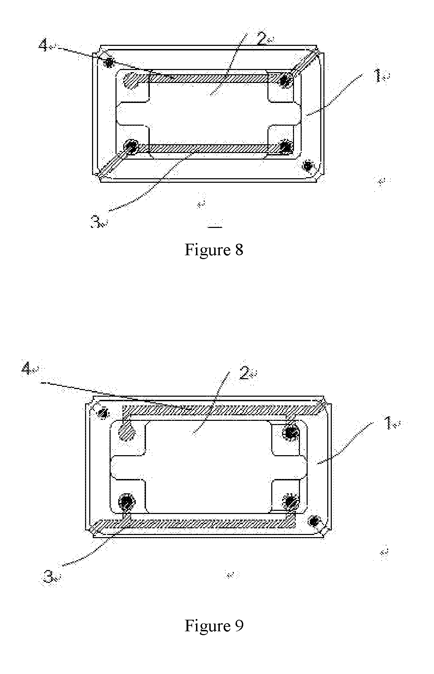

Figure 8 and Figure 9 respectively show the situations of corresponding adding the compensation metal slurry region 4 in Figure 3 and Figure 4 (a). The compensation metal slurry region here is in the structure of a compensation line so as to balance the shrinkage stress and effectively solve the problem of sintering deformation.

In addition, as shown in Figure 2 (a) and 2 (b), the package fixed layer comprises:
A package side wall layer 5 which is arranged on the periphery of the circuit layout layer;
At least two support layers 6 which are arranged on two sides of the circuit layout layer exposed from the package side wall layer 5;
And a cover body support layer 7 which is arranged on the package side wall layer 5. In addition, as shown in Figure 1 and Figure 2 (a) and 2 (b), the support layers in another structure are shown, and the support layers 6 are boss structures produced in the metal slurry region.

The structure of the package fixed layer as shown in Figure 4 (a) and 4 (b) is similar to that in Figure 2, so that the detailed description of the package fixed layer is omitted here.

### Embodiment 2

The embodiment is similar to Embodiment 1, the difference is that the metal slurry regions 3 and the compensation metal slurry regions 4 are in the same number and uniformly distributed in a mutual staggered manner; in addition, the different metal slurry regions 3 and the compensation metal slurry regions 4 can be arranged in other ways as long as the uniform arrangement is ensured.

The ceramic package base of the application is described in detail as above, for those of ordinary skill in the art, according to the idea of the embodiments of the application, the specific embodiment ways and the application ranges can make changes, for example, the package substrate can not only adopt the ceramic substrate, but also select other materials; the metal slurry regions and the compensation metal slurry regions are in the same number, the number can be two or more, but the premise is that the uniform and symmetrical distribution of the metal slurry regions and the compensation metal slurry regions on the package substrate needs to be ensured; in addition, the metal slurry patterns of the metal slurry regions and the compensation metal slurry regions can also be different or symmetrical or similar according to the practical situations as long as the uniform and symmetrical distribution degree is achieved. The metal slurry regions 3 and the compensation metal slurry regions 4 can also be electrically connected; and such changes fall within the protection scope of the application.

In addition, the key point of the application is the circuit design, the manufacturing process is the same with the general printing process, and the process is as follows: printing, drying and flattening.

## Claims

1. A ceramic package base comprising:
A package substrate (1), a circuit layout layer printed on the package substrate and a package fixed layer arranged on the periphery of the package substrate (1) and the circuit layout layer,
this ceramic package base (1) being **characterized in that** the circuit layout layer comprises at least one metal slurry region (3), at least one compensation metal slurry region (4) which corresponds to the metal slurry region being further arranged in a blank region (2) which is not provided with metal slurry(3).

2. The ceramic package base according to claim 1, **characterized in that** the package fixed layer comprises:
A package side wall layer (5) which is arranged on the periphery of the circuit layout layer;
At least two support layers (6) which are arranged on two sides of the circuit layout layer exposed from the package side wall layer (5);
And a cover body support layer (7) which is arranged on the package side wall layer (5).

3. The ceramic package base according to claim 2, **characterized in that** bosses are further produced in the metal slurry (3) region, and the support layers (6) are the bosses.

4. The ceramic package base according to any one of the preceding claims, **characterized in that** the metal slurry (3) region and the compensation metal slurry region (4) are uniformly distributed on the package substrate.

5. The ceramic package base according to any one of the preceding claims, **characterized in that** metal slurry patterns of the metal slurry (3) region and the compensation metal slurry region (4) are symmetrical or identical.

6. The ceramic package base according to any one of claim 1-5, **characterized in that** the metal slurry (3) region and the compensation metal slurry region (4) are not electrically connected.

7. The ceramic package base according to any one of claim 1-5, **characterized in that** the metal slurry (3) region and the compensation metal slurry region (4) are electrically connected.

8. The ceramic package base according to any one of claim 1-7, **characterized in that** the metal slurry (3) regions and the compensation metal slurry regions (4) are in the same number and symmetrically distributed on the package substrate.

9. The ceramic package base according to claim 8, **characterized in that** there is one metal slurry (3) region and one compensation metal slurry region (4).

10. The ceramic package base according to any one of the preceding claims, **characterized in that** the metal slurry regions (3) and the compensation metal slurry regions (4) are in the same number and distributed in a mutual staggered manner.
